(19) Europäisches Patentamt
European Patent Office
Office européen des brevets

(11) **EP 2 537 956 A1**

(12) **EUROPEAN PATENT APPLICATION**
published in accordance with Art. 153(4) EPC

(43) Date of publication:
**26.12.2012 Bulletin 2012/52**

(51) Int Cl.:
*C23C 16/44* (2006.01)   *H01L 21/205* (2006.01)
*H01L 21/677* (2006.01)   *H01L 31/04* (2006.01)

(21) Application number: **11744561.9**

(22) Date of filing: **09.02.2011**

(86) International application number:
**PCT/JP2011/052727**

(87) International publication number:
**WO 2011/102274 (25.08.2011 Gazette 2011/34)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.02.2010 JP 2010033529**

(71) Applicant: **Kaneka Corporation**
**Osaka-shi, Osaka 530-8288 (JP)**

(72) Inventors:
• **KURIBE, Eiji**
  **Osaka-shi**
  **Osaka 530-8288 (JP)**
• **TAKAHASHI, Takeyoshi**
  **Osaka-shi**
  **Osaka 530-8288 (JP)**

(74) Representative: **HOFFMANN EITLE**
**Patent- und Rechtsanwälte**
**Arabellastrasse 4**
**81925 München (DE)**

(54) **THIN FILM MANUFACTURING APPARATUS, THIN FILM MANUFACTURING METHOD, AND METHOD FOR MAINTAINING THIN FILM MANUFACTURING APPARATUS**

(57)   The present invention aims to provide a thin-film manufacturing equipment, a method for manufacturing a thin film, and a method for maintaining a thin-film manufacturing equipment, which are capable of depositing with high productivity even in occurrence of unexpected failure.

It is provided a thin-film manufacturing equipment including a group (42) of deposition chambers that is a collection of deposition chambers each provided with a deposition room, in which a thin film is deposited on a substrate, a movable chamber (6) designed to convey a substrate, and more than two substrate temporary keeping devices each for temporarily keeping a substrate, wherein the movable device is designed to deliver and receive the substrate to and from each of the deposition chambers and designed to perform at least one selected from a group consisting of receiving and discharging of the substrate from and to each of the more than two substrate temporary keeping devices.

FIG. 1

## Description

TECHNICAL FIELD

The present invention relates to a thin-film manufacturing equipment, a method for manufacturing a thin film, and a method for maintaining a thin-film manufacturing equipment, and more particularly to a thin-film manufacturing equipment, a method for manufacturing a thin film, and a method for maintaining a thin-film manufacturing equipment that include a plurality of deposition chambers and a movable chamber,

BACKGROUND ART

In recent years, power generation by solar cell panels have received attention due to escalating price of fossil materials such as oil and environmental consciousness in generating electricity. That is for such a reason that solar cells serve as a measure against finite nature of exhaustible fuels as generating electricity with sunlight and can be a measure to ease global warming as emitting no carbon dioxide in electrical generation.

. The solar cell is formed by laminating a semiconductor layer on a glass substrate (substrate). One of the known examples is a lamination of silicon-based p-layer, i-layer, and n-layer deposited on a glass substrate.

Deposition of these silicon semiconductor layers is often done by a plasma CVD method. The patent document 1 specified below discloses a CVD equipment for depositing such silicon semiconductor layers by a CVD method such as a plasma CVD method.

PATENT DOCUMENT

[Patent Document 1] JP 2005 -1395 24 A

DISCLOSURE OF INVENTION

TECHNICAL PROBLEM

The plasma CVD equipment disclosed in the patent document 1 includes four deposition chambers, a movable chamber, and a device for receiving and discharging substrates (substrate temporary keeping device). The deposition chambers each are a chamber having a deposition room, in which a film is deposited on a substrate. The movable chamber is a chamber being movable and loadable and conveyable substrates. The substrate receiving and discharging device is a device adapted to receive and discharge substrates from and to the movable chamber, being specifically delivering undeposited substrates (before deposition) to the movable chamber and receiving deposited substrates (after deposition) from the movable chamber.

The deposition chamber used in such the plasma CVD equipment is provided with precision equipment such as a vacuum pump, bringing about the possibility of generation of unexpected breakdown and/or failure. That requires repair and/or maintenance of the deposition chamber. Such repair and maintenance are normally performed after taking out the substrates from the failed deposition chamber.

However, the CVD equipment disclosed in the patent document 1 has a difficulty in taking out substrates if and when the deposition chamber suddenly needs to be repaired (maintained). Production process by the CVD equipment must be drastically stopped, which causes a problem of significantly reduced productivity in repair (maintenance).

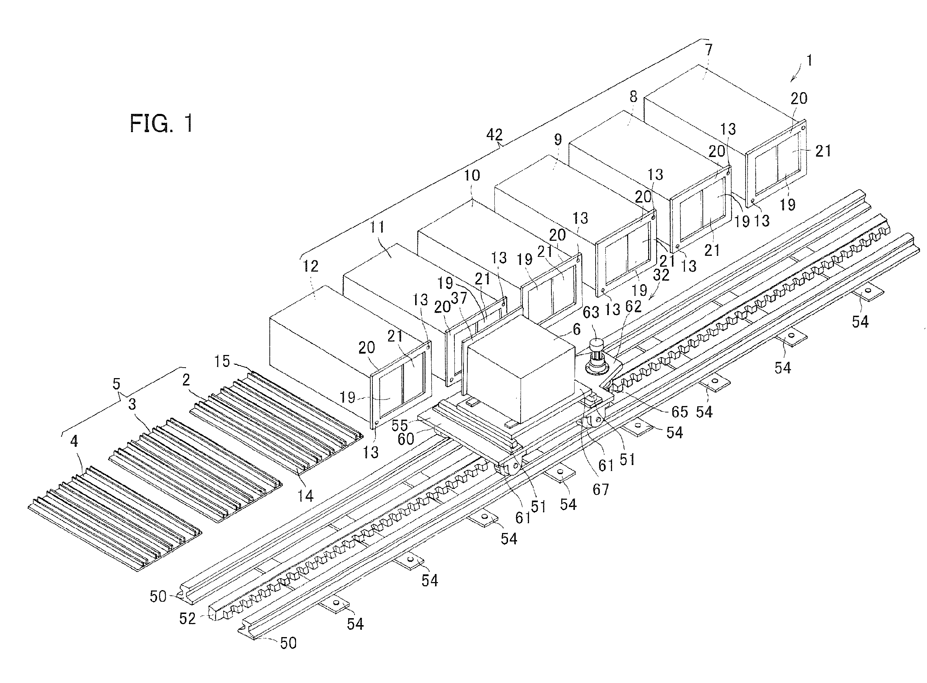

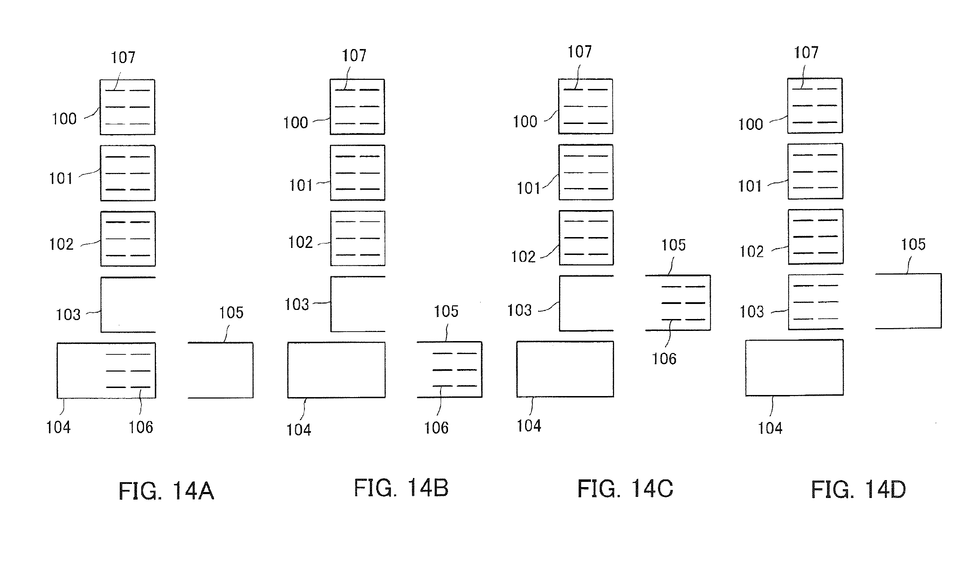

The CVD equipment as disclosed in Fig. 1 of the patent document 1 including the four deposition chambers, the substrate receiving and discharging device, and the movable chamber will be described as an example in detail below. In the CVD equipment as disclosed in the patent document 1 (hereinafter referred to as the conventional CVD equipment), referring to Fig. 14A, a movable chamber 105 is firstly moved in front of a substrate receiving and discharging device 104 on which substrates 106 are loaded. Next, the movable chamber 105 receives the substrates 106 from the substrate receiving and discharging device 104 (Fig. 14B) and moves to be in front of an empty deposition chamber 103 (Fig. 14C). Then, the substrates 106 are delivered to the deposition chamber 103 (Fig. 14D), so as to be deposited in the deposition chamber 103.

Assume that a deposition chamber 100 has broken down at this time. If the situation is as shown in Fig. 14D, the movable chamber 105 is moved to be in front of the deposition chamber 100, so as to take out the substrates 107 from the deposition chamber 100 and deliver them to the substrate receiving and discharging device 104. That empties the deposition chamber 100, which undergoes repair (maintenance). However, the substrates 107 remain in the substrate receiving and discharging device 104 all that time, occupying the substrate receiving and discharging device 104, resulting in failing to deliver substrates having been deposited in a deposition chamber 101 or a deposition chamber 102 to the next process.

If the situation is as shown in Fig. 14B or Fig. 14C, the movable chamber 105 is occupied by the substrates 106, thereby being unable to receive the substrates 107 from the deposition chamber 100 broken down.

If the situation is as shown in Fig. 14A, though the movable chamber 105 can receive the substrates 107 from the deposition chamber 100 broken down, the substrate receiving and discharging device 104 loads the substrates 106 being ready for the following deposition, resulting in no place for temporarily keeping the substrates 107.

As a result, in the conventional CVD device, production process must be stopped in maintenance. This problem occurs as well, as disclosed in paragraph [0180] in the patent document 1, even if the substrate receiving and discharging device 104 exclusively for discharging and receiving is disposed.

The present invention therefore aims to provide a thin-film manufacturing equipment, a method for manufacturing a thin film, and a method for maintaining a thin-film manufacturing equipment allowing deposition with a high productivity in the event of an unexpected failure or in a periodic maintenance.

SOLUTION TO PROBLEM

In order to solve the above-mentioned problem, an aspect of the present invention is a thin-film manufacturing equipment including a plurality of deposition chambers each having a deposition room, in which a thin film is deposited on a substrate, a movable device designed to convey a substrate, and more than two substrate temporary keeping devices each for temporarily keeping a substrate, wherein the movable device is designed to receive and deliver the substrate from and to each of the deposition chambers and designed to perform at least one selected from a group consisting of receiving and discharging of the substrate from and to each of the more than two substrate temporary keeping devices.

The thin-film manufacturing equipment of the present aspect includes more than two substrate temporary keeping devices and a plurality of deposition chambers. Thus, the equipment can appropriately dispose the substrate temporary keeping devices having separate functions like a substrate temporary keeping device exclusively for discharging a substrate, a substrate temporary keeping device exclusively for receiving a substrate, and a substrate temporary keeping device for temporarily keeping a substrate during repair (maintenance). The equipment can, for example, make ready to discharge an undeposited substrate (before deposition) to the movable chamber simultaneously with receipt of a deposited substrate (after deposition) from the movable chamber, with a substrate having been taken out from a deposition chamber to be repaired (maintained) temporarily displaced on the substrate temporary keeping device. That allows the movable chamber to receive an undeposited substrate immediately after discharging a deposited substrate to the substrate temporary keeping device regardless whether maintaining or not. In short, a time required for discharging and receiving a substrate to and from the movable chamber during maintenance is reduced compared with no substrate temporary keeping device for maintenance disposed therein, thereby enabling an efficient disposition.

Preferably, the substrate temporary keeping devices are aligned in a row along a moving direction of the movable device.

By the thin-film manufacturing equipment of the preferred aspect, the substrate temporary keeping devices are aligned in a row along a moving direction of the movable device. Thus, the substrate temporary keeping devices are narrowly spaced, so that the movable device moves a short way, which reduces a process time of deposition.

Further, disposition of the substrate temporary keeping devices in this way has scalability for a future additional arrangement. Specifically, an additional substrate temporary keeping device can be arranged in the thin-film manufacturing equipment only by adding a new substrate temporary keeping device in a row of the substrate temporary keeping devices and increasing a moving distance of the movable device for a distance of the added substrate temporary keeping device. Alternatively, the added substrate temporary keeping device can be removed only by removing the substrate temporary keeping device located at the end of the row and decreasing a moving distance of the movable device.

Preferably, the substrate temporary keeping devices includes a first substrate temporary keeping device for delivering an undeposited substrate to the movable device and a second substrate temporary keeping device for receiving a deposited substrate from the movable device, and further includes at least a third substrate temporary keeping device for temporarily keeping a substrate having been discharged from a deposition chamber to be maintained.

The thin-film manufacturing equipment of this preferred aspect includes the substrate temporary keeping device for temporarily keeping a substrate having been discharged from the deposition chamber to be maintained in addition to the substrate temporary keeping device for delivering an undeposited substrate to the movable device and the substrate temporary keeping device for receiving a deposited substrate from the movable device.

Thus, even when the substrate in the deposition chamber is displaced therefrom in maintenance, the displaced substrate never disturbs delivery and receipt of a substrate between the substrate temporary keeping device and the movable device.

Further, the discharging of an undeposited substrate and the receipt of a deposited substrate are executed by the respective substrate temporary keeping devices for exclusive use. Therefore, even if an unexpected failure occurs, the substrate temporary keeping device receives the deposited substrate from the movable device while the other substrate temporary keeping device keeps the undeposited substrate. Consequently, the movable device receives a substrate immediately after discharging of a substrate, and whereby a process time for deposition is reduced.

The number of the movable device is not limited to one. The thin-film manufacturing equipment of this aspect has such an advantageous effect as being capable of simultaneously executing at least two operations out of displacement of a substrate from the deposition chamber being maintained, delivery of an undeposited substrate to the movable device, and receipt of a deposited substrate from the movable device in a case of increasing the number of movable device.

Preferably, the thin-film manufacturing equipment satisfies the following formula relating to the total number X of the deposition chambers: T1 ≈ T2 (X-1) when T1 refers to a period of time required for deposition in the deposition chamber and T2 refers to a period of time required for the movable chamber to deliver a deposited substrate from the deposition chamber to the substrate temporary keeping device and to deliver an undeposited substrate from the substrate temporary keeping device to the deposition chamber.

Herein, "≈" means to make X the whole number by rounding off a fraction.

In the thin-film manufacturing equipment of this preferred aspect, the total number of the deposition chambers is preferably determined as described above. That is because too many or too few deposition chambers may fail to efficiently operate with the substrate temporary keeping devices and the movable device (movable chamber). This will be described in detail below.

By production of a thin film by the thin-film manufacturing equipment of this aspect, upon completion of deposition in the deposition chamber, the movable chamber executes a process such as discharging a deposited substrate from and delivering an undeposited substrate to the relevant deposition chamber. When a time (T2) required for this process is let be ten minutes and a time (T1) required for deposition in the deposition chamber is let be fifty minutes supposedly, depositions by six deposition chambers with a time shift by ten minutes make the deposition chambers and the movable chamber operate without a letup.

More specifically, when deposition in the deposition chamber in which a substrate has been firstly conveyed is completed after a lapse of sixty minutes from initiation of deposition process (starting of delivery of a substrate therein), the movable chamber executes the discharging and delivery of substrates from and to the relevant deposition chamber, during which ten minutes have passed (seventy minutes have passed after the initiation of the deposition process). At this moment, deposition in the deposition chamber having secondly started to deposit is completed. Then, the movable chamber executes the discharging and delivery of substrates from and to the deposition chamber having secondly started to deposit, during which another ten minutes have passed (eighty minutes have passed after the initiation of the deposition process). At this moment, deposition in the deposition chamber having thirdly started to deposit is completed. Upon sequential discharging and delivery of substrates in the same manner as the foregoing process, 120 (one hundred twenty) minutes have passed after the initiation of the deposition process at the time when the discharging and delivery of substrates from and to the chamber having lastly started to deposit has completed. Seventy minutes have passed from the initiation of deposition process at the time when the deposition chamber in which the deposition had firstly completed has undergone the discharging and delivery of substrates, and as further fifty minutes have passed, the second round of deposition has completed in the relevant deposition chamber. Hence, the movable chamber is executable discharging and delivery of substrates from and to the relevant deposition chamber. Repetition of those make the deposition chamber repeat sequential depositions and the movable chamber always work.

However, in a case of too few deposition chambers, the deposition chamber having had firstly started deposition has not completed the deposition even if substrates have been delivered into all the deposition chambers, rendering the movable chamber inevitable to halt until the deposition will have completed. Alternatively, in a case of too many deposition chambers, since the movable chamber is delivering substrates into the deposition chambers not having started to deposit yet even when the deposition chamber having had firstly started deposition has completed the deposition, the latter deposition chamber cannot discharge the deposited substrate and fails to execute sequential deposition. In sum, too many deposition chambers or too few deposition chambers fails to make the movable chamber or the deposition chambers operate without letup, leading to production inefficiency.

Preferably, the thin-film manufacturing equipment is designed to be used for manufacturing a solar cell module, wherein the solar cell module is a thin-film solar cell module formed by lamination of at least a first conducting layer, a first solar cell layer in which amorphous silicon-based p-layer, i-layer, and n-layer are laminated, a second solar cell layer in which crystalline silicon-based p-layer, i-layer, and n-layer are laminated, and a second conducting layer on a substrate, at least a part of each of the layers being divided into a plurality of cells by an optical beam processing, and the cells being electrically integrated one another, so as to deposit the first solar cell layer and the second solar cell layer in the deposition chamber.

Herein, in this preferred aspect, the term "crystalline" material includes one partly including an amorphous material.

Preferably, the thin-film manufacturing equipment is designed to be used for manufacturing a solar cell module, wherein the solar cell module is a thin-film solar cell module formed by lamination of at least a first conducting layer, a first solar cell layer in which amorphous silicon-based p-layer, i-layer, and n-layer are laminated, a second solar cell layer in which silicon germanium-based p-layer, i-layer, and n-layer are laminated, a third solar cell layer in which crystalline silicon-based p-layer, i-layer, and n-layer are laminated, and a second conducting layer on a substrate, at least a part of each of the layers being divided into a plurality of cells by an optical beam processing, and the cells being electrically integrated one another, so as to deposit the first solar cell layer, the second solar cell layer, and the third solar cell layer in the deposition chamber.

The thin-film manufacturing equipment of these preferred aspects are suitably usable also in manufacturing solar cell modules. That enables to produce solar cell modules with little reduced production efficiency in occurrence of an unexpected failure or execution of a periodic maintenance and with a high production efficiency.

Another aspect of the present invention is a method for manufacturing a thin film using the above-mentioned thin-film manufacturing equipment, the method satisfying the following relationship of the minimum number of Z: Z = Y (X+1) when Y refers to the number of the substrates, every deposition chamber being capable of depositing the same number Y of the substrates at a time, X refers to the total number of the deposition chambers, and Z refers to the number of the substrates accommodated in the thin-film manufacturing equipment after the substrates are conveyed to all the deposition chambers.

According to the method for manufacturing a thin film of this aspect, the number of substrate arranged in the thin-film manufacturing equipment is preferably the above-mentioned number Y (X+1) or more. That is because too few substrates arranged in the thin-film manufacturing equipment reduce a production efficiency of the thin-film manufacturing equipment. It will be described in detail below.

In order to efficiently operate the above-mentioned thin-film manufacturing equipment, every device constituting the thin-film manufacturing equipment preferably operates with reduced waiting time. There is a following method so as to operate in this way, for example. Firstly, the deposition chambers deposit with different completion time so as to sequentially complete the deposition after conveyance of the substrates in all the deposition chambers. Then, the movable device discharges the deposited substrate from the first deposition chamber and receives an undeposited substrate from the substrate temporary keeping device, so as to deliver it into the first deposition chamber. At this moment, the second deposition chamber completes deposition, so that the movable device discharges the deposited substrate from the second deposition chamber and delivers an undeposited substrate into the second deposition chamber in series. The foregoing method is one of the methods of manufacturing a thin film.

This method, compared with a method by which all the deposition chambers complete deposition at the same time, reduces a waiting time of the deposition chambers occurred for discharging and delivery of substrates. More specifically, in a case where all the deposition chambers complete the deposition at the same time, the movable device (movable chamber) is unable to discharge and deliver the substrates from and to a plurality of the deposition chambers at the same time and is forced to discharge and deliver the substrates from and to one deposition chamber by one in order. However, the discharging and delivery of the substrates from and to one deposition chamber by one in order makes any deposition chamber located in the back wait while the movable chamber discharges and delivers the substrates from and to the other deposition chambers. In contrast, by the above-mentioned method, the deposition chamber only waits for time required for discharging and delivery of the substrates from and to one deposition chamber.

In short, the above-mentioned method eliminates a waiting time from the movable device and reduces a waiting time from the deposition chambers.

However, in a case where the number of substrates arranged in the thin-film manufacturing equipment in the above-mentioned method is less than the above-mentioned number (Y (X+1)), the substrate temporary keeping device cannot keep an undeposited substrate to be delivered to the movable chamber in advance. That causes a waiting time for the movable device until starting to receive the substrate in delivering the substrate to the movable device. That also requires more time to deliver and discharge the substrates, resulting in increasing a waiting time for the deposition chambers. In sum, the number of substrates arranged in the thin-film manufacturing equipment being less than Y (X+1) reduces production efficiency.

Still another aspect of the present invention is a method for maintaining a thin-film manufacturing equipment, wherein the thin-film manufacturing equipment includes a plurality of deposition chambers each having a deposition room, in which a thin film is deposited on a substrate, a movable device designed to convey a substrate, and more than two substrate temporary keeping devices each for temporarily keeping a substrate, the method including the steps of taking out the substrate from the deposition chamber to be maintained to the movable device and discharging the substrate to the substrate temporary keeping device, in which the substrate is temporarily kept, and the thin-film manufacturing equipment executing at least one selected from a group consisting of a predetermined deposition and a conveyance of the substrate in parallel with a maintenance of the deposition chamber.

By the method for maintaining a thin-film manufacturing equipment of this aspect, the substrate in the deposition chamber to be maintained are displaced therefrom to the substrate temporary keeping device by the movable device. Then, the process of producing a thin film is executed simultaneously with execution of maintenance. Therefore, the maintenance is executed without reducing production efficiency of a thin film, and whereby production efficiency of the thin-film manufacturing equipment is increased.

Preferably, the substrate temporary keeping devices include at least a first substrate temporary keeping device for delivering an undeposited substrate to the movable device, the method further including the steps of discharging another substrate from the first substrate temporary keeping device to the movable device and moving the movable device to the vicinity of the deposition chamber being maintained before termination of the maintenance, and the movable device discharging the other substrate to the maintained deposition chamber following the termination of the maintenance of the deposition chamber.

By the method for maintaining a thin-film manufacturing equipment of this preferred embodiment, prior to termination of maintenance of the deposition chamber, the movable chamber receives an undeposited substrate from the substrate temporary keeping devices for supplying an undeposited substrate and moves to a position facing to the opening of the deposition chamber being maintained. That enables to arrange the undeposited substrate in the maintained deposition chamber immediately after the termination of the maintenance of the deposition chamber. That reduces a time for the deposition chamber to initiate deposition after termination of the maintenance, thereby ensuring deposition with a high production efficiency.

ADVANTAGEOUS EFFECTS OF INVENTION

The thin-film manufacturing equipment of the present invention ensures deposition with a high productivity in occurrence of unexpected failure or execution of periodic maintenance. Further, the method for manufacturing a thin film and the method for maintaining a thin-film manufacturing equipment of the present invention are also effective in normally manufacturing a thin film with high productivity as well.

BRIEF DESCRIPTION OF DRAWINGS

Fig. 1 is a perspective view of a thin-film manufacturing equipment relating to an embodiment of the present invention;
Fig. 2 is a perspective view of an essential part of a substrate moving device provided in each of a deposition chamber, a movable chamber, and a substrate temporary keeping device in Fig. 1;
Fig. 3 is a perspective view of an internal configuration of the deposition chamber in Fig. 1;
Fig. 4 is a partly broken cross-sectional plan view of the internal configuration of the deposition chamber in Fig. 1;
Fig. 5 is a perspective view of an electrode incorporated in the deposition chamber;
Fig. 6 is a perspective view of the movable chamber in Fig. 1, seen from a side of a doorway of a storage room;
Fig. 7 is a perspective view of inside of the movable chamber;
Fig. 8 is a cross-sectional plan view of an internal configuration of the movable chamber;
Fig. 9 is a cross section of a chamber moving device;

Fig. 10 is a perspective view of a substrate carrier used in the embodiment of the present invention;
Fig. 11 is an exploded perspective view of the substrate carrier in Fig. 10;
Fig. 12 is a partly broken perspective view of the movable chamber and the deposition chamber, where the substrate carrier moves from the movable chamber to the deposition chamber;
Fig. 13 is a flow chart showing a method for maintaining a thin-film manufacturing equipment relating to another embodiment of the present invention; and
Figs. 14A to 14D are explanatory views of the conventional CVD device, where substrates are moved and supplied to deposition chambers in order of 14A to 14D.

BEST MODE FOR EMBODYING THE INVENTION

Now, a thin-film manufacturing equipment and a method for maintaining a thin-film manufacturing equipment relating to embodiments of the present invention will be described in detail below, making reference to the accompanying drawings.

A thin-film manufacturing equipment 1 of the present embodiment is designed to form a semiconductor film on a substrate 46 made of glass. Referring to Fig. 1, the thin-film manufacturing equipment 1 of the present embodiment roughly consists of a group 5 of substrate temporary keeping devices, a group 42 of deposition chambers, and a movable chamber (movable device) 6.

The group 5 of substrate temporary keeping devices is constituted by three substrate temporary keeping devices and specifically by the substrate temporary keeping devices 2, 3, and 4. The substrate temporary keeping devices 2, 3, and 4 have the same configuration. Though this configuration will be described below, the description explains only the substrate temporary keeping device 2 and avoids repetition in a description of the substrate temporary keeping devices 3 and 4. Herein, the substrate temporary keeping device 2 is a device exclusively for delivering substrates 46 to the movable chamber 6, the substrate temporary keeping device 3 is a device exclusively for receiving substrates 46 from the movable chamber 6, and the substrate temporary keeping device 4 is a device exclusively for temporarily keeping in maintenance (repair). The substrate temporary keeping device 4 is used for temporarily keeping substrates taken out from the deposition chamber in repairing the deposition chamber. Further, when a substrate carrier 72 mentioned below is to be maintained or washed, the substrate temporary keeping device 4 is adapted to deliver and receive the target substrate carrier 72 to and from a device not shown and to deliver the cleaned and maintained substrate carrier 72 on which undeposited substrates 46 are carried into the movable chamber 6.

The substrate temporary keeping device 2 is, as shown in Fig. 1, composed of a base member 14 and five substrate moving devices 15.

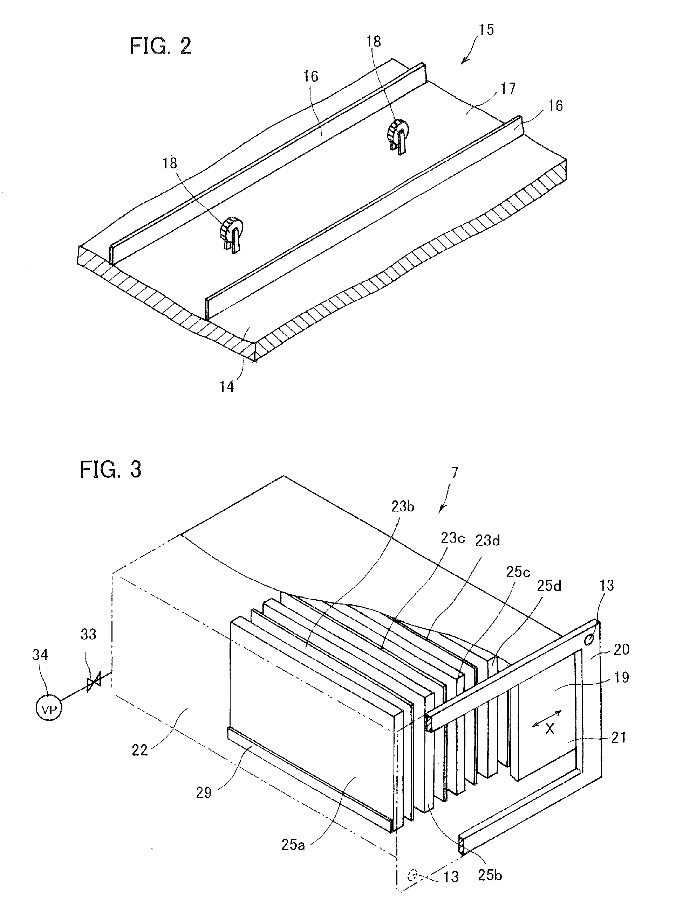

Each of the substrate moving devices 15 has a configuration shown in Fig. 2. Specifically, the substrate moving device 15 has two high ribs 16 extending in parallel, between which a guide groove 17 is formed. There are provided a plurality of pinion gears 18 at regular intervals in the guide groove 17. The pinion gears 18 rotate by a power not shown.

The group 42 of deposition chambers is, as shown in Fig. 1, constituted by deposition chambers 7 to 12, which have the same configuration. Though this configuration will be described below, the description explains only the deposition chamber 7 and avoids repetition in a description of the deposition chambers 8 to 12.

The deposition chamber 7 has an external appearance, as shown in Figs. 1 and 3, of a box shape with five closed faces (i.e., a top face, a bottom face, right and left side faces, and a rear face) and an open front face. The front face has a deposition-room doorway 19 with a rectangular opening. The doorway 19 has a flange 20 at its open end.

The flange 20 has a similar figure to the doorway 19, having a rectangular shape with two holes 13 at two diagonal corners among four corners.

The doorway 19 has an airtight shutter 21.

The shutter 21 employs a sliding gate valve, in which a door-like member is slidable in a direction of an arrow X in Fig. 3.
Herein, the shutter 21 is not limited to the above-mentioned sliding gate valve and may appropriately employ a swing door valve, for example.

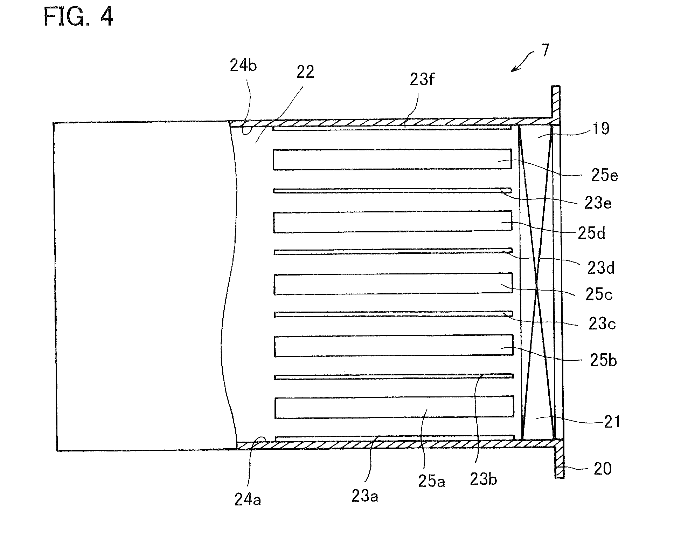

The deposition chamber 7 has inside, as shown in Fig. 4, a deposition room 22, in which the substrates 46 are deposited by a plasma CVD method. Referring to Figs. 3 and 4, the deposition room 22 has inside six plate-like sheet heaters 23a, b, c, d, e, and f and five electrodes 25a, b, c, d, and e. In Fig. 4, each of the heaters 23 (heaters 23a, b, c, d, e, and f) is shown as a thin rectangle, while each of the electrodes 25 (electrodes 25a, b, c, d, and e) is shown as a thick rectangle.

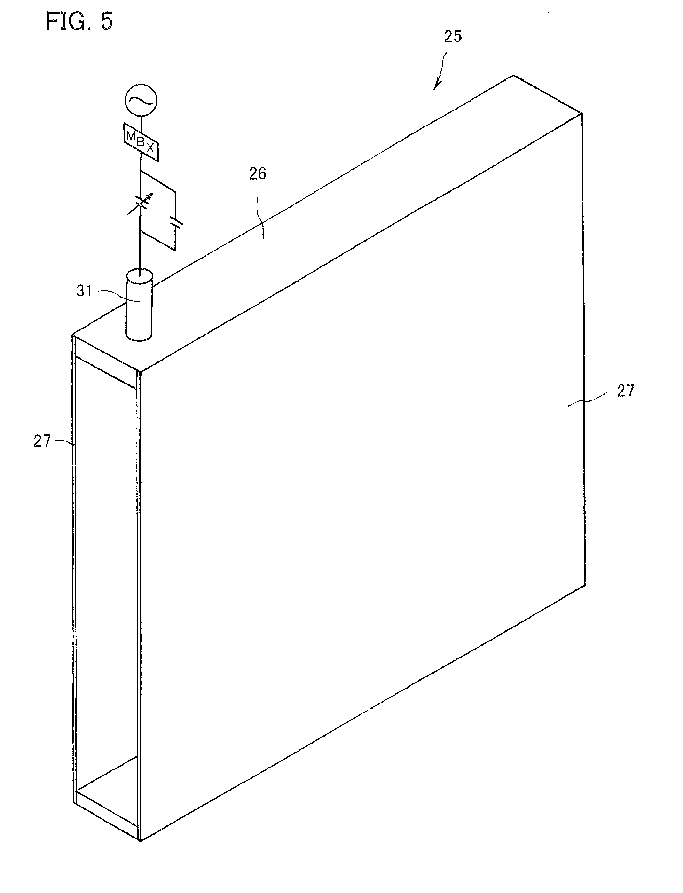

The electrode 25 (electrode 25a, b, c, d, and e) is, as shown in Fig. 5, composed of a frame 26 and shower plates 27 attached to both sides thereof.

A gas pipe 31 is connected to the frame 26 so as to be connected to a material gas supply source not shown. The frame 26 is connected to a high-frequency AC source via a matching circuit (MBX).

The deposition room 22 has therein substrate moving devices 29 each similar to the above-mentioned substrate moving device 15 (Fig. 2). The number of and the interval between the substrate moving devices 29 are equal to those of the substrate moving devices 15 disposed in the above-mentioned substrate temporary keeping device 2 (or the substrate temporary keeping device 3, 4) (Fig. 3).

As shown in Fig. 3, a vacuum pump (deposition-room pressure reducing device) 34 is connected to the deposition room 22 via a valve 33.

Next, the movable chamber 6 and the chamber moving device 32 will be described below.

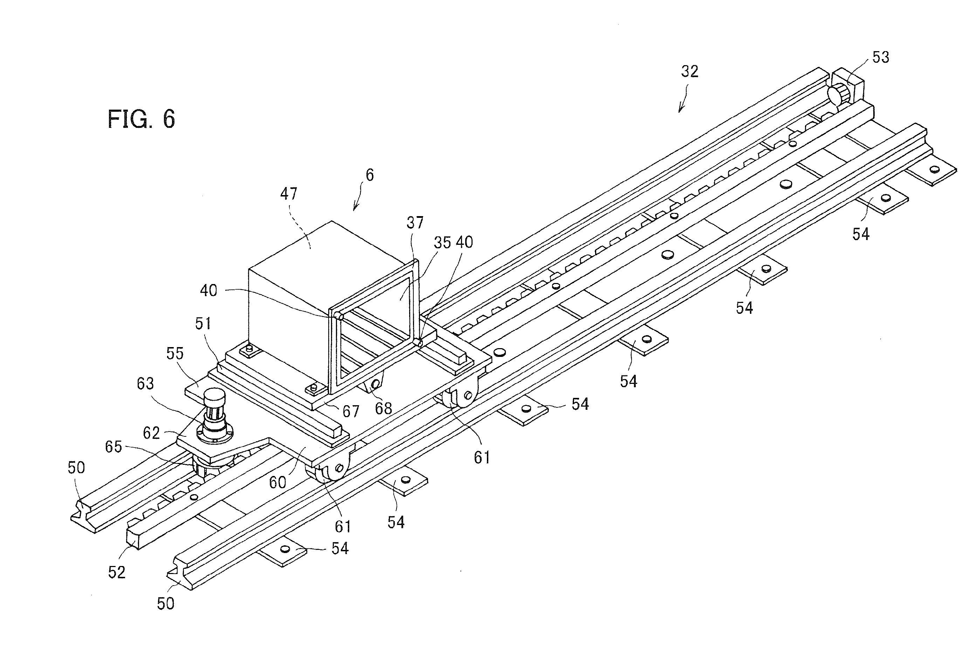

The movable chamber 6 is, as shown in Fig. 6, of a box shape with closed five faces (i.e., a top face, a bottom face, right and left side faces, and a rear face) and an open front face. The front face has a rectangular storage-room doorway 35. The storage-room doorway 35 has a flange 37 at its open end.

The storage-room doorway 35 and the flange 37 have the same size and shape as those of the deposition-room doorway 19 and the flange 20 of deposition chamber 7 mentioned above, respectively.

Though the flange 20 of the deposition chamber 7 has the holes 13 at the two diagonal corners among the four corners, the flange 37 of the movable chamber 6 has pins 40 at positions corresponding to those. The pins 40 each are tapered.

The storage-room doorway 35 of the movable chamber 6 has no closing member, so as to be normally open.
Herein, this embodiment employs the storage-room doorway 35 being open, but the present invention is not limited thereto and may have a nonairtight door only for preventing dust from outside. In short, it is necessary to have no airtight member.

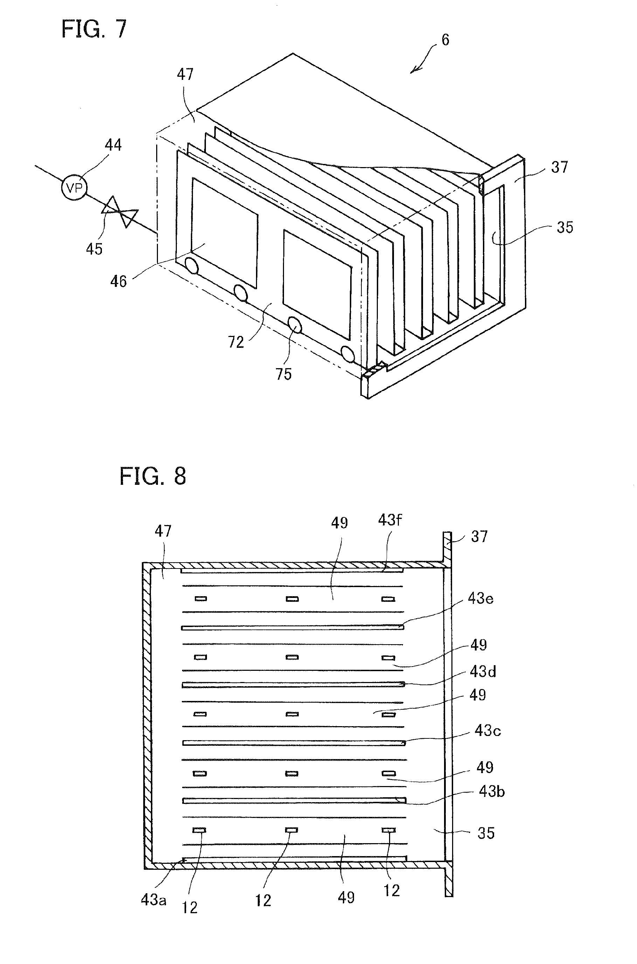

Referring to Fig. 7, the movable chamber 6 has inside a storage room 47 for storing the substrates 46.

The storage room 47 has substrate moving devices 49 each similar to the substrate moving device 15 and the substrate moving device 29 described above therein (see Fig. 8). The number of and the interval between the substrate moving devices 49 are equal to those of the substrate moving devices 15 and 29 disposed in the above-mentioned substrate temporary keeping devices 2, 3, 4 and the deposition room 22 described above.

Referring to Fig 8, the storage room 47 in the movable chamber 6 has inside six heaters 43a, b, c, d, e, and f, which have the same configurations as those of the six heaters 23a, b, c, d, e, and f disposed in the deposition room 22 in the deposition chamber 7 (Fig. 4). Positional relationships between the six heaters 43a, b, c, d, e, and f in the movable chamber 6 are the same as those between the six heaters 23a, b, c, d, e, and f disposed in the deposition room 22 in the deposition chamber 7.
In this regard, the number of and the positions of the heaters (heaters 43a to 43f) in the storage room 47 are not limited to the above-mentioned configuration. There may be provided, for example, five heaters 43a, b, c, d, and e at positions opposite to the electrodes 25a, b, c, d, and e in the deposition chamber at the time when the movable chamber 6 is engaged with the deposition chamber. With the heaters arranged at these positions, each of the heaters is positioned in a void 74 (described in detail below) between frames 77 when the substrate carriers 72 are stored in the storage room 47, thereby reducing a heating time because the heaters come more closer to the substrates 46.

The chamber moving device 32 is designed to move the movable chamber 6 in a transverse direction and an anteroposterior direction, as shown in Figs. 1 and 6, being movable along rails 50 in the transverse direction and along straight guides 51 in the anteroposterior direction.

The chamber moving device 32 has a pair of rails 50 extending in the transverse direction. The rails 50 each have the same cross-sectional shape as that of the known rail for a train. The rails 50 are fixed to sleepers 54 disposed on a floor via the known tie plates or the like.

There is provided an elongated rack 52, as shown in Figs. 1 and 6, attached between the rails 50 with its tooth face situated sideways.

Further, there is provided a stopper 53, as shown in Fig. 6, attached to an end part of the rails 50. The stopper 53 is designed to stop a movable carriage 55 described below from overrunning and incorporates a known shock absorber.

Referring to Figs. 1 and 6, the movable carriage 55 is placed on the rails 50. The movable carriage 55 is formed by a base board 60 with four wheels 61 attached to a bottom face of the board 60. In this embodiment, the wheels 61 is allowed free rotation and placed on the rails 50.

The base board 60 further has an overhang 62 at a part thereof, which is equipped with an electric motor drive 63, such as a geared motor, being rotatable at a low speed. The electric motor drive 63 is attached to the base board 60 with its rotational shaft (not shown) projecting to the bottom face of the board 60. The pinion gear 65 is attached to the rotational shaft and engaged with the rack 52 disposed between the rails 50.

Consequently, rotation of the electric motor drive 63 rotates the pinion gear 65, so that the movable carriage 55 runs upon reaction force received from the rack 52. In this embodiment, the movable carriage 55 has a vacuum pump 44 (Fig. 7).

Herein, the configuration for running the movable carriage 55 is not limited to the above-mentioned rack and pinion system and may be a system of directly rotating the wheels via a motor or the like.

There are provided the above-mentioned straight guides 51 on the top face of the base board 60 of the movable carriage 55. The straight guides 51 are arranged in two rows in parallel and in a direction perpendicular to the rails 50 on the floor.

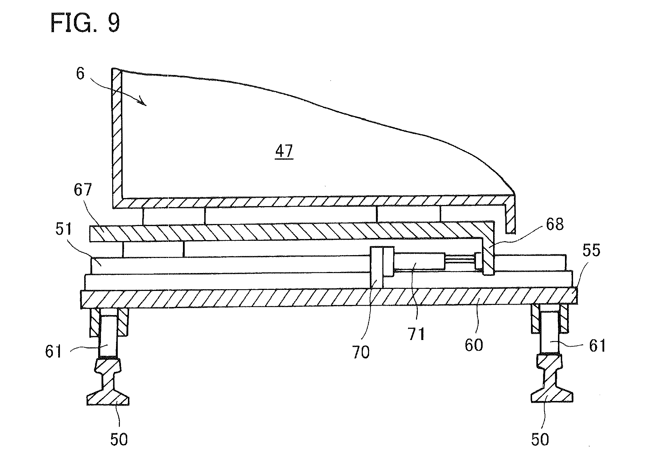

As shown in Fig. 6, there is provided a movable board 67 disposed on the above-mentioned straight guides 51. The above-mentioned movable chamber 6 is, as shown in Figs. 6 and 9, fixed to the movable board 67.

There is further provided a movable bracket 68 (see Figs. 6 and 9) near the front side of the movable board 67 (near the storage-room doorway 35 of the movable chamber 6) and in the center thereof. The movable bracket 68 is a plate projecting from the bottom face of the movable board 67.

On the other hand, there is provided a fixed bracket 70, as shown in Fig. 9, on the top face of the base board 60. A hydraulic or pneumatic cylinder 71 is attached between the fixed bracket 70 and the movable bracket 68. Thus, expansion and contraction of a rod of the cylinder 71 make the movable board 67 above the base board 60 move linearly along the straight guides 51 in the direction perpendicular to the rails 50, so that the movable chamber 6 on the movable board 67 is linearly moved in the anteroposterior direction (in a direction close to or away from any deposition chamber constituting the group 42 of deposition chambers).

The movable board 67 has the vacuum pump 44 (shown in Fig. 7 and not shown in Figs. 1 and 6 for convenience of drawing figures). The vacuum pump 44 functions as a storage-room pressure reducing device and is connected to the storage room 47 in the movable chamber 6 as shown in Fig. 7.

Next, the substrate carrier 72 for carrying the substrates 46 will be described in detail below.

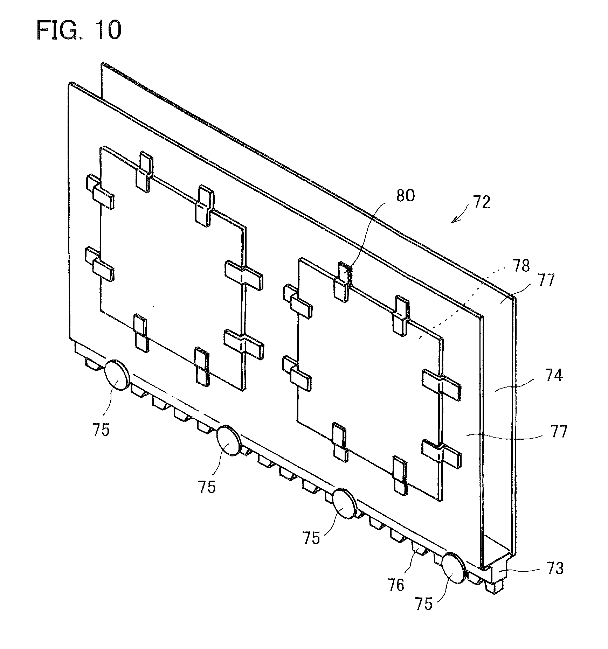

Referring to Fig. 10, the substrate carrier 72 has a shape with the two frames 77 facing each other and vertically extending on an elongated carriage. Specifically, the substrate carrier 72 includes a cuboid carrier base 73 with eight wheels 75 at both sides in total. The carrier base 73 has a rack 76 at its bottom.

The two frames 77 are arranged in parallel on longer edges of the top face of the carrier base 73. The two frames 77 define the void 74 therebetween. Specifically, the carrier base 73 and the two frames 77 forms an angular U shape.

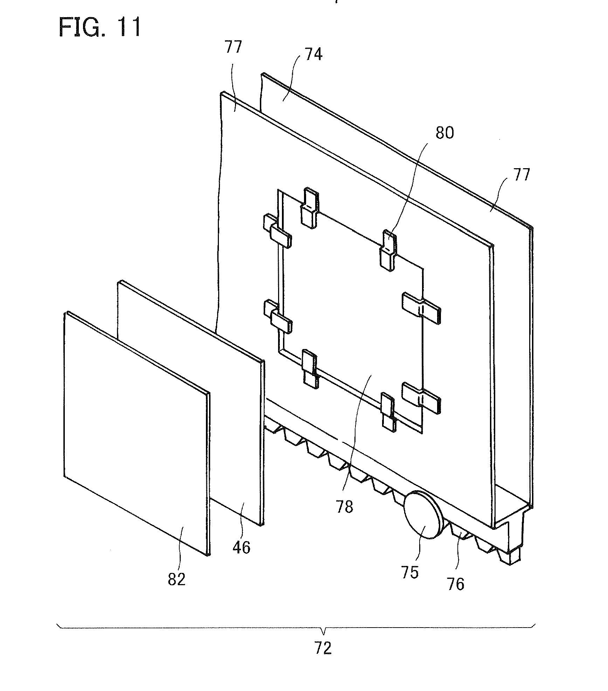

Each of the frames 77, as shown in Figs. 10 and 11, has two square openings 78, around which a number of clips 80 are attached.

Referring to Fig. 11, the substrates (glass substrates) 46 and back boards 82 respectively overlapping therewith are fit on the frame 77 of the substrate carrier 72 and pressed by the clips 80.

Consequently, the substrate (glass substrate) 46 has an exposed face facing inward of the opposed frame 77.

Next, a total layout of the thin-film manufacturing equipment 1 of the present embodiment will be described in detail below.

In the thin-film manufacturing equipment of the present embodiment, as shown in Fig. 1, the six deposition chambers constituting the group 42 of deposition chambers are arranged in a horizontal row with their deposition-room doorways 19 facing to the same direction. The group 5 of substrate temporary keeping devices is positioned on the same side of the group 42 of deposition chambers. The substrate temporary keeping devices 2 to 4 constituting the group 5 of substrate temporary keeping devices each are arranged in a horizontal row so that an extension of the guide groove 15 in a longitudinal direction is situated perpendicular to the rails 50.

The six deposition chambers constituting the group 42 of deposition chambers and the three substrate temporary keeping devices constituting the group 5 of substrate temporary keeping devices are firmly secured to the floor, so as to be steady.

Then, as shown in Fig. 1, the rails 50 of the chamber moving device 32 are arranged along the front side of the group 42 of deposition chambers and the group 5 of substrate temporary keeping devices. As described above, the movable chamber 6 is placed on the rails 50 via the movable carriage 55. The storage-room doorway 35 (see Fig. 6) of the movable chamber 6 faces to the deposition-room doorways 19 of the deposition chambers 7 to 12.

In this embodiment, rotation of the electric motor drive 63 of the chamber moving device 32 makes the movable carriage 55 run, so that the movable chamber 6 moves in a column-wise direction of the group 42 of deposition chambers.

Further, extension and contraction of the cylinder 71 of the chamber moving device 32 make the movable chamber 6 move in the direction closer to and away from the group 42 of deposition chambers (Fig. 9).

Next, a method for manufacturing a thin film using the thin-film manufacturing equipment 1 of this embodiment will be described in detail below.

In the preparatory stages for the method for manufacturing a thin film of this embodiment, the deposition rooms 22 in the respective six deposition chambers 7 to 12 constituting the group 42 of deposition chambers each are reduced in pressure. Specifically, after the shutter 21 of each of the deposition-room doorways 19 has been closed, the vacuum pump (deposition-room pressure reducing device) 34 is activated and the valve 33 is opened, so as to extract air in the deposition room 22 (Fig. 3). Meanwhile, the substrates 46 are fit on the substrate carriers 72.

In the method for manufacturing a thin film of this embodiment, the substrate temporary keeping device 2 is used exclusively for discharging undeposited substrates 46 (substrate carriers 72) (before deposition) to the movable chamber 6, whereas the substrate temporary keeping device 3 is used exclusively for receiving deposited substrates 46 (substrate carriers 72) (after deposition) from the movable chamber 6. Hereinafter, the substrate temporary keeping device 2 is referred to as a discharging device 2, while the substrate temporary keeping device 3 is referred to as a receiving device 3. Firstly, the substrate carriers 72 are set in the discharging device 2. Specifically, each of the substrate carriers 72 is placed on the discharging device 2, so that the wheels 75 of the substrate carrier 72 are let into the guide groove 17 of the substrate moving device 15 of the discharging device 2. At this time, the rack 76 attached to the bottom face of the substrate carrier 72 is engaged with the pinion gears 18 of the substrate moving device 15 disposed in the discharging device 2.

Then, the following series of working process are automatically performed by a controller not shown.

The controller not shown organically operates the discharging device 2, the receiving device 3, the movable chamber 6, and the group 42 of deposition chambers, so as to deposit silicon-based p-layer, i-layer, and n-layer on each of the substrates 46.

Specifically, when the substrate carriers 72 have been put on the discharging device 2, the movable chamber 6 moves to a position corresponding to the discharging device 2. More specifically, the movable chamber 6 moves in a column-wise direction of the group 42 of deposition chambers, then stopping in front of the discharging device 2. Positioning is executed by counting the rotational number of the electric motor drive 63, providing the known limit switch, or the like.

Then, the pinion gears 18 of the substrate moving devices 15 disposed in the discharging device 2 and the pinion gears 18 of the substrate moving devices 49 disposed in the movable chamber 6 rotate. That makes the substrate carriers 72 move forward to the movable chamber 6. The substrate carriers 72 having moved to the movable chamber 6 partly enter the movable chamber 6.

As described above, since the pinion gears 18 of the substrate moving devices 49 of the movable chamber 6 also rotate, the racks 76 of the substrate carriers 72 each are engaged with the pinion gears 18 of the movable chamber 6, thereby bringing the substrate carriers 72 into the storage room 47 in the movable chamber 6.

In this embodiment, the discharging device 2 is provided with five rows of the substrate moving devices 15, whereby five substrate carriers 72 are set in the discharging device 2. The number, the interval, and the like of the substrate moving devices 15 disposed in the discharging device 2 are the same as those of the substrate moving devices 49 of the movable chamber 6. Consequently, all the five substrate carriers 72 having been set in the discharging device 2 are conveyed therefrom into the movable chamber 6, so as to be accommodated in the storage room 47.

Herein, the five substrate carriers 72 may be moved at a time or in order. The same can be said to the movement of the substrate carriers 72 from the movable chamber 6 to each of the deposition chambers 7 to 12, the movement of the substrate carriers 72 from each of the deposition chambers 7 to 12 to the movable chamber 6, the movement of the substrate carriers 72 from the movable chamber 6 to the receiving device 3, and the movement of the substrate carriers 72 from the movable chamber 6 to the substrate temporary keeping device 4. Those movements can be performed at a time or individually.

When all the five substrate carriers 72 having been set in the discharging device 2 are conveyed therefrom to the movable chamber 6, which means no substrate carrier 72 remains on the discharging device 2, other substrate carriers 72 on which undeposited substrates 46 having been fit again are replenished on the discharging device 2. This replenishment is automatically executed. Herein, removal of deposited substrates 46 from the substrate carriers 72 and fitting of undeposited substrates 46 on the substrate carriers 72 are executed by a robot not shown.

Further, this replenishment can be executed also while at least one of return of deposited substrates 46 from the movable chamber 6 to the receiving device 3 and repair (maintenance), which are described later, is executed. In other words, in the method for manufacturing a thin film of this embodiment, regardless of being engaged on repair (maintenance), other substrates 46 (substrate carriers 72) to be deposited next are put on the discharging device 2 while the movable chamber 6 makes the substrates 46 convey to the receiving device 3. In sum, this method is always ready to deliver undeposited substrates 46 to the movable chamber 6. Therefore, the substrate carriers 72 are immediately delivered to the movable chamber 6, which reduces time required for a deposition process.

Upon confirmation of the delivery of all the substrate carriers 72 to the movable chamber 6, the movable chamber 6 moves again in the column-wise direction, then stopping in front of the deposition chamber 7 adjacently located. Herein, in this embodiment, only the delivery of the substrate carriers 72 to the deposition chamber 7 is described and the same description about the delivery of the substrate carriers 72 from the movable chamber 6 to any of the deposition chambers 8 to 12 is omitted.

The cylinder 71 of the movable chamber 6 expands, thereby moving the movable chamber 6 to a direction approaching the deposition chamber 7.

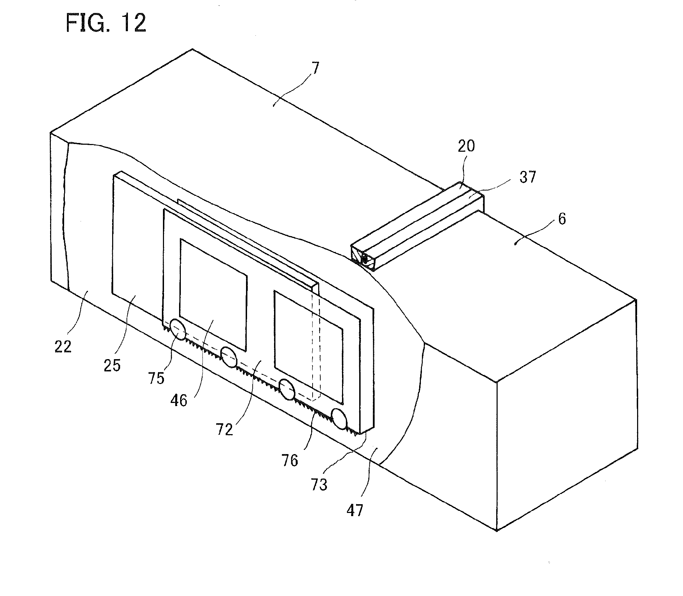

As shown in Fig. 12, the movable chamber 6 is brought into contact with the deposition chamber 7 end to end at last.

Specifically, the storage-room doorway 35 of the movable chamber 6 fits closely to the deposition-room doorway 19 of the deposition chamber 7 with the flange 37 of the movable chamber 6 fitting closely to the flange 20 of the deposition chamber 7, so that the flange 37 of the movable chamber 6 pressing the flange 20 of the deposition chamber 7.

As described above, the deposition-room doorway 19 of the deposition chamber 7 has the airtight shutter 21, which closes the storage room 47 to form a closed space in the movable chamber 6.

Upon confirmation of the complete fitting of the flange 37 of the movable chamber 6 and the flange 20 of the deposition chamber 7, the vacuum pump (storage-room pressure reducing device) 44 is activated and the valve 45 is opened, so as to extract air in the closed space defined by the storage room 47 and the shutter 21 of the deposition chamber 7, thereby reducing pressure to evacuate.

When the above-mentioned closed space reaches a predetermined degree of vacuum, the six heaters 43a, b, c, d, e, and f in the storage room 47 in the movable chamber 6 are increased in temperature to heat and increase in temperature the substrates 46 therewithin.

Upon confirmation of the substrates 46 reaching a predetermined temperature, the shutter 21 of the deposition chamber 7 is opened. Herein, the deposition room 22 in the deposition chamber 7 has been already under high vacuum. At this time, as described above, air is extracted also from the closed space defined by the storage room 47 and the shutter 21 of the deposition chamber 7, which renders also the closed space in high vacuum. Therefore, even when the shutter 21 of the deposition chamber 7 is opened, the deposition room 22 keeps the degree of vacuum.

Then, upon confirmation of complete opening of the shutter 21, the pinion gears 18 of the substrate moving devices 49 of the movable chamber 6 and the pinion gears 18 of the substrate moving devices 29 of the deposition room 22 in the deposition chamber 7 are rotated. The rotational direction of the pinion gears 18 this time is opposite to that in the delivery of the substrate carriers 72 to the movable chamber 6.

The rotation of the pinion gears 18 moves the substrate carriers 72 toward the storage-room doorway 35. Specifically, the substrate carriers 72 move from the movable chamber 6 toward the deposition room 22 in the deposition chamber 7, then entering the deposition room 22 in the deposition chamber 7. At this time, as described above, the pinion gears 18 of the substrate moving devices 29 of the deposition chamber 7 are also rotating. Thus, the racks 76 of the substrate carriers 72 are engaged with the pinion gears 18 of the deposition chamber 7, so that the substrate carriers 72 are brought into the deposition room 22 in the deposition chamber 7.

Referring to Fig. 12, the rectangular carrier base 73 of the substrate carrier 72 enters a gap (see Fig. 5) underneath each of the electrodes 25 (electrodes 25a, b, c, d, and e, see Fig. 4), while the frames 77 of the substrate carrier 72 enter the sides of each of the electrodes 25 (electrodes 25a, b, c, d, and e). Then, as shown in Fig. 4, there exist the six heaters 23a, b, c, d, e, and f in the deposition room 22, in which each of the electrodes 25a, b, c, d, and e and each of the heaters 23a, b, c, d, e, and f are alternately arranged, so that each of the substrates 46 is inserted in between any of the heaters 23 and any of the electrodes 25.

Upon confirmation of the delivery of all the substrate carriers 72 into the deposition room 22 in the deposition chamber 7 and the arrangement of those at predetermined positions, the shutter 21 of the deposition chamber 7 is closed. Then, silicon semiconductors are deposited on the substrates 46 on the substrate carriers 72 in the deposition room 22 in the deposition chamber 7.

Specifically, with material gas supplied into the frame 26 of each of the electrodes 25a, b, c, d, and e and high-frequency alternate current applied to each of the electrodes 25a, b, c, d, and e, glow discharge is generated between the electrodes 25a, b, c, d, and e and the substrate carriers 72 so as to decompose the material gas, thereby forming a thin film on a surface of each of the vertically arranged substrates 46.

This embodiment forms thin layers constituting a solar cell in the deposition room 22 in the one deposition chamber 7. Specifically, a solar cell is formed by lamination of semiconductor layers composed of a p-layer, an i-layer, and an n-layer, and this embodiment sequentially laminates the semiconductor layers composed a p-layer, an i-layer, and an n-layer in the deposition room 22 in the one deposition chamber 7.

Additionally, this embodiment introduces air or nitrogen into the storage room 47 in the movable chamber 6 while the deposition process is executed in the deposition chamber 7, so as to equalize the pressure in the storage room 47 and the outside atmospheric pressure. Specifically, air or nitrogen is introduced into the storage room 47 having been reduced in pressure inside and being empty after the substrate carriers 72 have been taken out, thereby equalizing the pressure in the storage room 47 and the outside atmospheric pressure.

After elimination of a difference in pressure between inside the storage room 47 and an ambient air, the cylinder 71 of the chamber moving device 32 is contracted, so as to move the movable chamber 6 in a direction away from the deposition chamber 7. In short, the movable chamber 6 having contacted with the deposition chamber 7 is separated from the deposition chamber 7.

Then, the electric motor drive 63 of the movable chamber 6 is rotated again, thereby making the movable carriage 55 of the movable chamber 6 run along the rails 50 toward the column-wise direction of the group 42 of deposition chambers and stop in front of the discharging device 2.

Thereafter, as well as the previous process, the substrate carriers 72 having been set in the discharging device 2 are conveyed therefrom to the storage room 47 in the movable chamber 6, the movable carriage 55 of the movable chamber 6 is made run along the rails 50 and stop in front of the deposition chamber 8, which is the second deposition chamber, and the movable chamber 6 and the deposition chamber 8 are brought into contact with each other end to end.

Then, a closed space defined by the storage room 47 and the shutter 21 of the deposition chamber 8 is reduced in pressure and the substrates 46 therein are heated and increased in temperature by the heaters 43 a, b, c, d, e, and f.

Then, the shutter 21 of the deposition chamber 8 is opened so that the substrate carriers 72 in the movable chamber 6 are conveyed therefrom into the deposition room 22 in the deposition chamber 8, and is closed to perform deposition.

The substrates 46 are sequentially introduced into the deposition chambers (deposition chambers 7 to 12) constituting the group 42 of deposition chambers in this way, so that semiconductor layers composed of a p-layer, an i-layer, and an n-layer are laminated in each of the deposition chambers.

Then, the substrate carriers 72 are sequentially discharged from the deposition chambers (deposition chambers 7 to 12) having completed the lamination process and returned to the receiving device 3.

In this embodiment, the movable chamber 6 is used also for this returning work.

Specifically describing, when there exists any deposition chamber having completed all the deposition work among the group 42 of six deposition chambers or any deposition chamber reaching the end of the deposition work, the movable chamber 6 being empty without the substrate carriers 72 is connected to the relevant deposition chamber.

More specifically, the movable carriage 55 of the empty movable chamber 6 is made run along the rails 50 and stop in front of the deposition chamber having completed the deposition work. Then, the movable chamber 6 is moved forward so as to be brought into contact with the relevant deposition chamber end to end. The flange 37 of the movable chamber 6 is pressed onto the flange 20 of the relevant deposition chamber. Hereinafter, only a case of the deposition chamber 7 having completed the deposition will be described and the same description about a case of the deposition chambers 8 to 12 is omitted.

Thereafter, the vacuum pump 44 reduces pressure in the closed spaced defined by the storage room 47 and the shutter 21 of the deposition chamber 7.

Then, the shutter 21 is opened, so that the deposited substrates 46 are delivered from the deposition chamber 7 to the movable chamber 6. Specifically, the pinion gears 18 of the substrate moving devices 15 in the deposition chamber 7 and the movable chamber 6 are rotated in a direction opposite to the foregoing case, thereby conveying the substrate carriers 72 in the deposition chamber 7 toward the deposition-room doorway 19 of the deposition chamber 7 and further letting the substrate carriers 72 into the storage room 47 in the movable chamber 6.

Upon confirmation of the delivery of all the substrate carriers 72 to the movable chamber 6, the shutter 21 is closed and air or nitrogen is introduced into the storage room 47 in the movable chamber 6.

After elimination of a difference in pressure between inside the storage room 47 and an ambient air, the cylinder 71 of the movable chamber 6 is contracted, so as to move the movable chamber 6 in a direction away from the deposition chamber 7 and separate the movable chamber 6 from the deposition chamber 7. Then, the electric motor drive 63 of the chamber moving device 32 is rotated again, thereby making the movable carriage 55 run along the rails 50 toward the column-wise direction of the group 42 of deposition chambers and stop in front of the receiving device 3.

Thereafter, the pinion gears 18 of the substrate moving devices 15 in the movable chamber 6 and the substrate temporary keeping device 3 are rotated, thereby conveying the substrate carriers 72 in the movable chamber 6 therefrom into the receiving device 3.

This process is repeated afterward, thereby executing lamination of thin films on the substrates 46.

Herein, this embodiment lets a combined total time T2 of time spent from when the movable chamber 6 takes out the substrate carriers 72 from the deposition chamber 7 till when the movable chamber 6 delivers the substrate carriers 72 to the receiving device 3 and time spent from when the movable chamber 6 receives the substrate carriers 72 from the discharging device 2 till when the movable chamber 6 discharges the substrate carriers 72 to the deposition chamber 7 be thirty minutes and a time T1 required for deposition in each deposition chamber be two hours and thirty minutes. Besides, the number X of the deposition chambers constituting the group 42 of deposition chambers is let be six. Consequently, there are provided the deposition chambers constituting the group 42 of deposition chambers so as to satisfy a formula T1 ≈ T2 (X-1). The starting time of a first deposition in each deposition chamber is shifted by 30 minutes (T2).

Therefore, after completion of the deposition in the deposition chamber 7, thirty minutes (T2) will have elapsed at the time when the movable chamber 6 has discharged the deposited substrates 46 (substrate carriers 72) therefrom and has delivered other undeposited substrates 46 thereinto, and meanwhile, the deposition in the deposition chamber 8 has completed. Such sequential discharging from and delivering into each deposition chamber constituting the group 42 of deposition chambers in this way lead to discharge and deliver the substrates 46 from and into the five deposition chambers, during which two hours and thirty minutes will have elapsed. At this time, the deposition has completed in the deposition chamber 7 again. In short, the thin-film manufacturing equipment 1 of this invention make each of the deposition chambers constituting the group 42 of deposition chambers and the movable chamber 6 operate successively while the above-mentioned process is repeated, ensuring to be efficient.

This embodiment lets the total number X of the deposition chambers be six, as described above, and the number Y of substrates being depositable at a time be twenty. The number Y is determined by that the number of the substrates 46 being carried by one substrate carrier 72 is let be four and that the five substrate carriers 72 are simultaneously managed in each of the deposition chambers, the movable chamber 6, and the substrate temporary keeping devices 2 to 4. Further, the thin-film manufacturing equipment 1 lets the number Z of substrates managed therein be 140 (one hundred forty) when the thin-film manufacturing equipment 1 operates so as to have the maximum capacity of producing thin films. More specifically, the number Z of substrates managed in the thin-film manufacturing equipment 1 is let be 140 (one hundred forty) when all the deposition chambers of the thin-film manufacturing equipment 1 are used to deposit and while all the deposition chambers repeatedly perform deposition from the time when the movable chamber 6 has started to convey the substrates 46 so as to deliver the substrates 46 to the sixth (Xth) deposition chamber after completion of delivery of the substrates 46 to the five (X-1) deposition chambers. In sum, the number Z is let be the minimal number satisfying the formula Z = Y(X+1). Specifically, assuming that five substrate carriers 72 is let be of one set, the thin-film manufacturing equipment 1 is designed to manage the substrate carriers 72 of more than six sets calculated by adding one to the total number six of the deposition chambers.

That, for example, enables the discharging device 2 in advance to prepare one set of the substrate carriers 72 carrying other substrates 46 thereon while each of the five deposition chambers is performing deposition of one set of the substrate carriers 72 and while the movable chamber 6 is conveying one set of the substrate carriers 72 carrying the deposited substrates 46 thereon. Thereby, the movable chamber 6 can receive the other substrates 46 (one set of the substrate carriers 72 having been prepared in advance) immediately after delivering the deposited substrates 46 (one set of substrate carriers 72) to the receiving device 3, so that a time required for conveying substrates is reduced.

In other words, the thin-film manufacturing equipment 1 of this embodiment can manage the number of sets of the substrate carriers 72 exceeding the total number of the deposition chambers, thereby enabling delivery and receipt of the substrates 46 (substrate carriers 72) between each of the substrate temporary keeping devices constituting the group 5 of substrate temporary keeping devices and the movable chamber 6, so as to efficiently operate.

Herein, the above-mentioned condition "when the thin-film manufacturing equipment 1 operates so as to have the maximum capacity of producing thin films" is not limited to the above-mentioned situation. It depends on how to operate the thin-film manufacturing equipment 1. In a case of simultaneous deposition in all the deposition chambers without shifting deposition completion time, for example, the condition becomes "when all the deposition chambers in the thin-film manufacturing equipment 1 are used to deposition and while all the deposition chambers repeatedly deposit after the substrates have been conveyed into all the deposition chambers". Further, the thin-film manufacturing equipment 1 may manage more than six sets of the substrate carriers. The thin-film manufacturing equipment 1 may manage eight sets of substrate carriers in cases of a long time taken to deliver the substrate carriers 72 to outside of the thin-film manufacturing equipment 1 such that the deposited substrates 46 are taken out from the substrate carriers 72 on the receiving device 3 or an addition of the movable chamber 6 and the group 5 of substrate temporary keeping devices, for example. It is only necessary to quickly deliver and receive the substrates 46 between each of the members consisting of the deposition chambers, the movable chamber 6, and the substrate temporary keeping devices.

Herein, the number of the substrate carriers 72 being simultaneously managed by each of the deposition chambers, the movable chamber 6, and the substrate temporary keeping devices may be appropriately modified and may be more than five or less than five. The above-mentioned number Y is changeable depending on the modification. Additionally, the number of the substrates 46 being carried by one substrate carrier 72 may be also appropriately modified and may be more than four or less than four.

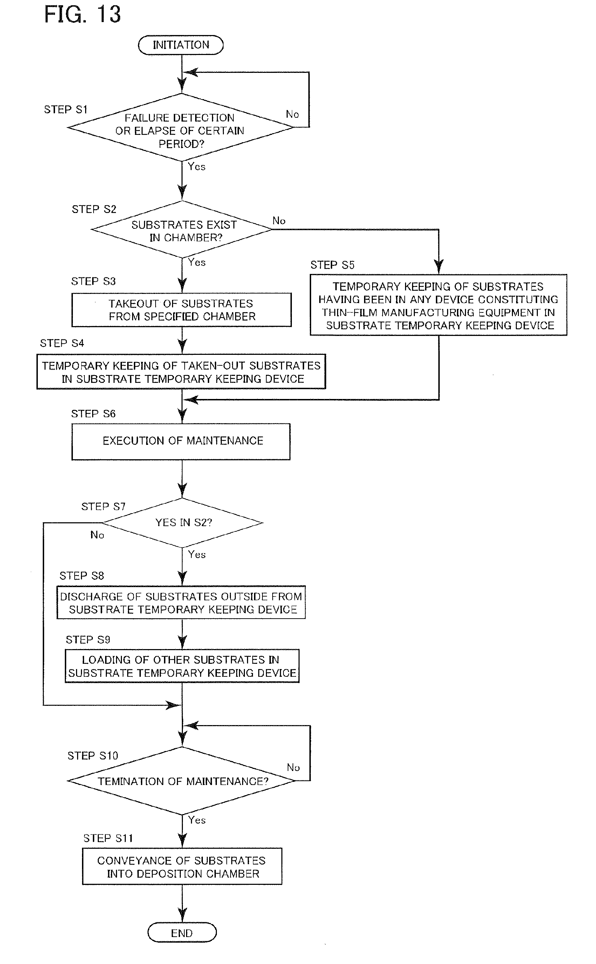

Next, a performance of repair (maintenance) of the thin-film manufacturing equipment 1 using more than two substrate temporary keeping devices, which is the characteristic configuration of the present invention, will be described in order, making reference to Figs. 1 and 13. Herein, the substrate temporary keeping device 4 is a device exclusively for temporarily keeping the substrates 46 in maintenance.

Upon satisfaction of special conditions such as any failure detected in any of the chambers constituting the group 42 of deposition chambers by a controller or the like not shown or execution of a periodic maintenance after the elapse of a specified time, the maintenance work is initiated in the relevant chamber (step S1).

The description below explains a case of maintenance of the deposition chamber 7 and avoids repetition in a description of the other deposition chambers 8 to 12.

Upon initiation of the maintenance, a controller not shown confirms whether the substrates 46 (substrate carriers 72) exist in the failed deposition chamber 7 or not (step S2)

In a case where no substrate 46 (substrate carrier 72) exists in the failed deposition chamber 7, the substrates 46 (substrate carriers 72) in any device constituting the thin-film manufacturing equipment 1 are conveyed therefrom into the storage room 47 in the movable chamber 6, which conveys the substrates 46 and delivers them to the substrate temporary keeping device 4 (step S5). Specifically, at the initiation of the maintenance, the substrates 46 in a discretionary device among the substrates 46 (substrate carriers 72) in any of the discharging device 2, the receiving device 3, the movable chamber 6, the deposition chambers 8 to 12 are conveyed therefrom to the substrate temporary keeping device 4. That is because the substrates 46 are not delivered and received between the devices since every device to which the substrates 46 in any device are to be delivered therefrom has already kept the substrates 46 if all devices of the discharging device 2, the receiving device 3, the movable chamber 6, the deposition chambers 8 to 12 keep the substrates 46.

Upon completion of step S5, the maintenance work to the failed deposition chamber 7 is started (to step S6).

In a case where the substrates 46 exist in the failed deposition chamber 7, the substrates 46 (substrate carriers 72) in the deposition room 22 in the failed deposition chamber 7 are conveyed therefrom into the storage room 47 in the movable chamber 6 (step S3), which conveys the substrates and delivers them into the substrate temporary keeping device 4 (step S4). Thereafter, the maintenance work to the failed deposition chamber 7 is started (to step S6).

Specifically, in steps S3 and S4, the empty movable chamber 6 is moved in the column-wise direction of the group 42 of deposition chambers by the chamber moving device 32, so as to be stopped in front of the failed deposition chamber 7. Then, the movable chamber 6 is connected to the deposition chamber 7. The pinion gears 18 of the substrate moving devices 15 of the deposition chamber 7 and the movable chamber 6 are rotated, thereby letting the substrate carriers 72 in the deposition chamber 7 therefrom into the storage room 47 in the movable chamber 6.

Then, the movable chamber 6 is moved toward the group 5 of substrate temporary keeping devices and stopped in front of the substrate temporary keeping device 4, so that the substrates 46 are conveyed from the movable chamber 6 to the device 4. Specifically, the pinion gears 18 of the substrate moving devices 15 of the movable chamber 6 and the substrate temporary keeping device 4 are rotated in the opposite direction from the foregoing case, thereby conveying the substrates 46 (substrate carriers 72).

Herein, in cases where the existence of the substrates 46 (substrate carriers 72) within the deposition chamber 7 has been confirmed in step S2 (step S7) and the substrates 46 within the deposition chamber 7 have been conveyed therefrom to the substrate temporary keeping device 4 in step S4, the following processing is performed during execution of the maintenance to the deposition chamber 7 in step S6. During the maintenance, the substrate temporary keeping device 4 delivers the substrates 46 (substrate carriers 72) having been within the deposition chamber 7 therefrom to an external device not shown (step S8). Then, the substrate carriers 72 carrying undeposited substrates 46 are delivered from an external device not shown to the substrate temporary keeping device 4 (step S9).

Herein, the substrate temporary keeping device 4 is only used in execution of maintenance. Consequently, the substrates 46 having been kept within the deposition chamber 7 before the maintenance are temporarily kept and delivered therefrom to outside during the maintenance without preventing a series of process relating to deposition by the thin-film manufacturing equipment 1.

Upon confirmation of completion of the maintenance of the deposition chamber 7 (step S10), the movable chamber 6 receives other undeposited substrates 46 (substrate carriers 72) on the substrate temporary keeping device 4 therefrom or the substrates 46 (substrate carriers 72) having been temporarily kept in step S5 therefrom and delivers them into the deposition chamber 7 by the above-mentioned process (step S11). Then, the thin-film manufacturing equipment 1 returns to the production system by all the deposition chambers including the deposition chamber 7.

Now, maintenance by a thin-film manufacturing equipment provided with two substrate temporary keeping devices (without the substrate temporary keeping device 4) different from the present invention, that is, maintenance with the substrates 46 in the deposition chamber to be maintained temporarily kept in the discharging device 2 or in the receiving device 3, will be described below.

In a case where the substrates 46 in the deposition chamber to be maintained are discharged therefrom and temporarily kept in the discharging device 2, for example, the discharging device 2 must deliver the substrates 46 temporarily kept to an external device not shown and receive other substrates 46 to be deposited after the maintenance from an external device not shown during the maintenance of the deposition chamber. That renders the discharging device 2 incapable of delivering other substrates 46 to be deposited in the deposition chamber not in maintenance (operating normally) to the movable chamber 6 during the maintenance of the deposition chamber. In short, during the maintenance of the deposition chamber, the discharging device 2 fails to execute the normal process for deposition.

That requires the receiving device 3 to deliver other substrates 46 to the movable chamber 6 and to receive the deposited substrates 46 from the movable chamber 6. However, if and when the receiving device 3 conduct the two processes of the delivery and receipt described above, the receiving device 3 cannot receive undeposited substrates 46 while, for example, receiving the deposited substrates 46 from the movable chamber 6 and delivering the received deposited substrates 46 to an external device. In sum, the receiving device 3 fails to make ready for delivery of undeposited substrates 46 simultaneously with receipt of the deposited substrates 46.

Hence, unlike in a case of a division of the delivery and receipt described above by the discharging device 2 the receiving device 3, the movable chamber 6 takes extra standby time for time required for preparing undeposited substrates 46 on the substrate temporary keeping device until the movable chamber 6 starts to receive other substrates 46 from the substrate temporary keeping device after having delivered the deposited substrates 46 to the substrate temporary keeping device. That results in reduced production efficiency of the thin-film manufacturing equipment. Such a problem occurs as well in a case where the substrates 46 in the deposition chamber to be maintained are discharged therefrom and temporarily kept in the receiving device 3.

However, the thin-film manufacturing equipment 1 relating to the embodiment of the present invention has no such the problem since being provided with the substrate temporary keeping device 4 to be used exclusively in maintenance. The maintenance is executed without disturbing the normal deposition process, so that manufacturing of a thin film with little reduced production efficiency during the maintenance of the deposition chamber and with a high production efficiency is achieved.

Herein, in the above-mentioned embodiment, the maintenance of the deposition chamber 7 starts after the substrates 46 have been delivered to the substrate temporary keeping device 4, but the substrates 46 have not been necessarily loaded on the substrate temporary keeping device 4 on initiation of the maintenance. The maintenance can be started immediately after the substrates 46 have been conveyed from the deposition chamber 7 into the movable chamber 6. In short, it is only necessary that no substrate 46 (substrate carrier 72) exists in the deposition chamber 7 on execution of the maintenance of the deposition chamber 7.

In the above-mentioned embodiment, the movable chamber 6 receives the substrate carriers 72 carrying undeposited substrates 46 from the substrate temporary keeping device 4, but a method of delivering undeposited substrates 46 to the movable chamber 6 is not limited thereto. The movable chamber 6 may receive undeposited substrates 46 from the discharging device 2 or from the receiving device 3 with the substrates 46 in the deposition chamber discharged therefrom and temporarily kept on the substrate temporary keeping device 4. However, the receipt from the substrate temporary keeping device 4 is preferable since less affecting to a series of process relating to deposition by the thin-film manufacturing equipment 1.

Further, the substrate temporary keeping device 4 is, as shown in Fig.1, arranged adjacent to the substrate temporary keeping device 2 and the substrate temporary keeping device 3 and along the rails 50 into line with the other substrate temporary keeping devices. Additionally, the substrate temporary keeping device 4 has the same substrate moving devices 15 as those of the substrate temporary keeping device 2 and of the substrate temporary keeping device 3, so as to deliver and receive the substrates 46 (substrate carriers 72) to and from the movable chamber 6 through similar mechanisms to each of the substrate temporary keeping devices.

Therefore, it is not necessary to change designs and/or arrangements of other components in cases of addition of the substrate temporary keeping device (addition of the substrate temporary keeping device 4 newly for maintenance) or removal of the added substrate temporary keeping device, for example. That facilitates a configuration change of the thin-film manufacturing equipment 1.

The above-mentioned embodiment uses only one substrate temporary keeping device 4 used for maintenance (repair), but the number of that is not limited thereto. It is possible to provide a plurality of substrate temporary keeping devices 4, for example.

Herein, provision of a plurality of substrate temporary keeping devices 4 used for maintenance (repair) enables every substrate temporary keeping device 4 to divide every work in maintenance (repair), which allows efficient work of maintenance (repair). Now, maintenance of the substrate carriers 72 by a thin-film manufacturing equipment provided with three substrate temporary keeping devices 4 for maintenance will be described in detail below.

First, the movable chamber 6 delivers the substrate carriers 72 to be maintained (cleaned) to a first substrate temporary keeping device 4. The first substrate temporary keeping device 4 delivers the substrate carriers 72 to a device not shown, which maintains (cleans) the substrate carriers 72. Meanwhile, the movable chamber 6 conducts the normal deposition work. Subsequently, a device not shown delivers the substrate carriers 72 having completed the maintenance (cleaning) and carrying other substrates 46 to a second substrate temporary keeping device 4. The movable chamber 6 lastly receives the substrate carriers 72 from the second substrate temporary keeping device 4 and delivers them to an appropriate deposition chamber.

The above-mentioned method for maintenance lets the substrate temporary keeping device 4 for receiving the substrate carriers 72 to be maintained from the movable chamber 6 be the first substrate temporary keeping device 4 and the substrate temporary keeping device 4 for receiving the maintained substrate carriers 72 from the device not shown and delivering them to the movable chamber 6 be the second substrate temporary keeping device 4.

That allows, for example, the second substrate temporary keeping device 4 to prepare the other maintained (cleaned) substrate carriers 72 to be delivered to the movable chamber 6 while the movable chamber 6 is delivering the substrate carriers 72 to be maintained (cleaned) to the first substrate temporary keeping device 4. Thereby, the movable chamber 6 can receive the other maintained (cleaned) substrate carriers 72 from the second substrate temporary keeping device 4 immediately after having delivered the substrate carriers 72 to be maintained (cleaned) to the first substrate temporary keeping device 4. That reduces a time required for the movable chamber 6 to receive the substrate carriers 72 from the second substrate temporary keeping device, thereby reducing a time required for the maintenance of the substrate carriers 72. Further, since there is provided a third normally-nonoperating substrate temporary keeping device 4 in the method for maintenance, if and when any unexpected failure occurs in any of the deposition chambers during the maintenance of the substrate carriers 72 and results in the necessity for conveyance of the substrate carriers 72 from the relevant deposition chamber out, the substrate carriers 72 in the relevant deposition chamber are discharged therefrom and temporarily kept in the third substrate temporary keeping device, so that the deposition chamber is undergone the maintenance without disturbing the maintenance of the substrate carriers 72.

A thin film manufactureed by the thin-film manufacturing equipment and the method for manufacturing a thin film of the present invention is not particularly limited, but is suitably used, for example, for deposition of a so-called a thin-film solar cell. Specifically, these are usable for manufacturing a thin-film solar cell module, which is a solar cell module formed by processing multi-junction solar cells, formed by lamination of at least a first conducting layer, a first solar cell layer in which amorphous silicon-based p-layer, i-layer, and n-layer are laminated, a second solar cell layer in which crystalline silicon-based p-layer, i-layer, and n-layer are laminated, and a second conducting layer on a substrate, at least a part of each of the layers being divided into a plurality of cells by an optical beam processing, the cells being electrically integrated one another. The first solar cell layer and the second solar cell layer are deposited. In sum, the present invention is employed as a device for a preceding process before the optical beam processing.

Further, it is not limited to deposition of a two-layer thin film solar cell including a light-absorbing layer consisting of amorphous silicon and crystalline silicon, and may be suitably used for deposition of a three-layer thin film solar cell including a silicon germanium layer or deposition of a thin-film solar cell formed by lamination of more than two light-absorbing layers like three or four layers, for example.

BRIEF DESCRIPTION OF NUMERALS

1. thin-film manufacturing equipment
2, 3, 4. substrate temporary keeping device
6. movable chamber (movable device)
7, 8, 9, 10, 11, 12. deposition chamber

**Claims**

1. A thin-film manufacturing equipment comprising:

   a plurality of deposition chambers each having a deposition room, in which a thin film is deposited on a substrate;
   a movable device designed to convey a substrate; and
   more than two substrate temporary keeping devices each for temporarily keeping a substrate, wherein the movable device is designed to receive and deliver the substrate from and to each of the deposition chambers and designed to perform at least one selected from a group consisting of receiving and discharging of the substrate from and to each of the more than two substrate temporary keeping devices.

2. The thin-film manufacturing equipment as defined in claim 1,
   the substrate temporary keeping devices being aligned in a row along a moving direction of the movable device.

3. The thin-film manufacturing equipment as defined in claim 1 or 2,
the substrate temporary keeping devices including a first substrate temporary keeping device for delivering an undeposited substrate to the movable device and a second substrate temporary keeping device for receiving a deposited substrate from the movable device, and
the substrate temporary keeping devices further including at least a third substrate temporary keeping device for temporarily keeping a substrate having been discharged from a deposition chamber to be maintained.

4. The thin-film manufacturing equipment as defined in one of claims 1 to 3, satisfying the following formula relating to the total number X of the deposition chambers:

$$T1 \approx T2\,(X\text{-}1)$$

when T1 refers to a period of time required for deposition in the deposition chamber and T2 refers to a period of time required for the movable chamber to deliver a deposited substrate from the deposition chamber to the substrate temporary keeping device and to deliver an undeposited substrate from the substrate temporary keeping device to the deposition chamber.

5. The thin-film manufacturing equipment as defined in one of claims 1 to 4,
being designed to be used for manufacturing a solar cell module,
wherein the solar cell module is a thin-film solar cell module formed by lamination of at least a first conducting layer, a first solar cell layer in which amorphous silicon-based p-layer, i-layer, and n-layer are laminated, a second solar cell layer in which crystalline silicon-based p-layer, i-layer, and n-layer are laminated, and a second conducting layer on a substrate, at least a part of each of the layers being divided into a plurality of cells by an optical beam processing, and the cells being electrically integrated one another,
so as to deposit the first solar cell layer and the second solar cell layer in the deposition chamber.

6. The thin-film manufacturing equipment as defined in one of claims 1 to 4,
being designed to be used for manufacturing a solar cell module,
wherein the solar cell module is a thin-film solar cell module formed by lamination of at least a first conducting layer, a first solar cell layer in which amorphous silicon-based p-layer, i-layer, and n-layer are laminated, a second solar cell layer in which silicon germanium-based p-layer, i-layer, and n-layer are laminated, a third solar cell layer in which crystalline silicon-based p-layer, i-layer, and n-layer are laminated, and a second conducting layer on a substrate, at least a part of each of the layers being divided into a plurality of cells by an optical beam processing, and the cells being electrically integrated one another,
so as to deposit the first solar cell layer, the second solar cell layer, and the third solar cell layer in the deposition chamber.

7. A method for manufacturing a thin film using the thin-film manufacturing equipment as defined in one of claims 1 to 6,
satisfying the following relationship of the minimum number of Z:

$$Z = Y\,(X\text{+}1)$$

when Y refers to the number of the substrates, every deposition chamber being capable of depositing the same number Y of the substrates at a time, X refers to the total number of the deposition chambers, and Z refers to the number of the substrates accommodated in the thin-film manufacturing equipment after the substrates are conveyed to all the deposition chambers.

8. A method for maintaining a thin-film manufacturing equipment,
wherein the thin-film manufacturing equipment comprises a plurality of deposition chambers each having a deposition room, in which a thin film is deposited on a substrate, a movable device designed to convey a substrate, and more than two substrate temporary keeping devices each for temporarily keeping a substrate,
the method comprising the steps of:

taking out the substrate from the deposition chamber to be maintained to the movable device; and
discharging the substrate to the substrate temporary keeping device, in which the substrate is temporarily kept,, and
the thin-film manufacturing equipment executing at least one selected from a group consisting of a predetermined deposition and a conveyance of the substrate in parallel with a maintenance of the deposition chamber.

9. The method as defined in claim 8,

wherein the substrate temporary keeping devices include at least a first substrate temporary keeping device for delivering an undeposited substrate to the movable device,

the method further comprising the steps of:

discharging another substrate from the first substrate temporary keeping device to the movable device and moving the movable device to the vicinity of the deposition chamber being maintained before termination of the maintenance, and

the movable device discharging the other substrate to the maintained deposition chamber following the termination of the maintenance of the deposition chamber.

EP 2 537 956 A1

FIG. 1

FIG. 2

FIG. 3

FIG. 4

FIG. 5

FIG. 6

## FIG. 7

## FIG. 8

FIG. 9

FIG. 10

FIG. 11

FIG. 12

# FIG. 13

INITIATION

STEP S1 — FAILURE DETECTION OR ELAPSE OF CERTAIN PERIOD? — No

Yes

STEP S2 — SUBSTRATES EXIST IN CHAMBER? — No

Yes

STEP S3 — TAKEOUT OF SUBSTRATES FROM SPECIFIED CHAMBER

STEP S4 — TEMPORARY KEEPING OF TAKEN-OUT SUBSTRATES IN SUBSTRATE TEMPORARY KEEPING DEVICE

STEP S5 — TEMPORARY KEEPING OF SUBSTRATES HAVING BEEN IN ANY DEVICE CONSTITUTING THIN-FILM MANUFACTURING EQUIPMENT IN SUBSTRATE TEMPORARY KEEPING DEVICE

STEP S6 — EXECUTION OF MAINTENANCE

STEP S7 — YES IN S2? — No

Yes

STEP S8 — DISCHARGE OF SUBSTRATES OUTSIDE FROM SUBSTRATE TEMPORARY KEEPING DEVICE

STEP S9 — LOADING OF OTHER SUBSTRATES IN SUBSTRATE TEMPORARY KEEPING DEVICE

STEP S10 — TEMINATION OF MAINTENANCE? — No

Yes

STEP S11 — CONVEYANCE OF SUBSTRATES INTO DEPOSITION CHAMBER

END

FIG. 14A

FIG. 14B

FIG. 14C

FIG. 14D

<table>
<tr><td colspan="2" align="center">**INTERNATIONAL SEARCH REPORT**</td><td>International application No.<br>PCT/JP2011/052727</td></tr>
</table>

**A. CLASSIFICATION OF SUBJECT MATTER**
*C23C16/44*(2006.01)i, *H01L21/205*(2006.01)i, *H01L21/677*(2006.01)i, *H01L31/04*(2006.01)i

According to International Patent Classification (IPC) or to both national classification and IPC

**B. FIELDS SEARCHED**

Minimum documentation searched (classification system followed by classification symbols)
C23C16/44, H01L21/205, H01L21/677, H01L31/04

Documentation searched other than minimum documentation to the extent that such documents are included in the fields searched
Jitsuyo Shinan Koho          1922-1996   Jitsuyo Shinan Toroku Koho   1996-2011
Kokai Jitsuyo Shinan Koho   1971-2011   Toroku Jitsuyo Shinan Koho   1994-2011

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2005-139524 A  (Kaneka Corp.),<br>02 June 2005 (02.06.2005),<br>claim 1; paragraphs [0070] to [0075], [0123] to [0180]; fig. 1<br>(Family: none) | 1-9 |
| Y | JP 2009-147266 A  (Mitsubishi Heavy Industries, Ltd.),<br>02 July 2009 (02.07.2009),<br>claim 1; paragraphs [0040] to [0042], [0061] to [0063]; fig. 3, 7<br>& EP 2224499 A1        & WO 2009/078209 A1<br>& CN 101689582 A | 1-9 |

☒ Further documents are listed in the continuation of Box C.    ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>11 March, 2011 (11.03.11) | Date of mailing of the international search report<br>05 April, 2011 (05.04.11) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2011/052727

C (Continuation). DOCUMENTS CONSIDERED TO BE RELEVANT

| Category* | Citation of document, with indication, where appropriate, of the relevant passages | Relevant to claim No. |
|---|---|---|
| Y | JP 11-345859 A (Tokyo Electron Ltd.), 14 December 1999 (14.12.1999), claim 1; paragraph [0016]; fig. 1 (Family: none) | 1-9 |
| Y | JP 2006-120745 A (Mitsubishi Heavy Industries, Ltd.), 11 May 2006 (11.05.2006), claim 1; paragraphs [0030] to [0031]; fig. 2 & US 2006/0086385 A1 & EP 1650814 A1 & CN 1770479 A & AU 2005225062 A | 5,6 |
| Y | JP 2003-282902 A (Kyocera Corp.), 03 October 2003 (03.10.2003), claims 16, 17; paragraph [0045] (Family: none) | 5,6 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2005139524 A